# EUROPEAN PATENT APPLICATION

(11) **EP 2 661 146 A2**
(43) Date of publication of application: **06.11.2013**
(21) Application number: 11750210.4
(22) Date of filing: 20.04.2011
(51) Int. Cl.: H04W 88/08, H04W 88/16, H04W 28/06

(54) **DATA TRANSMISSION METHOD, RADIO ACCESS NETWORK EQUIPMENT, WIRELESS GATEWAY AND SYSTEM**

(71) Applicant: Huawei Technologies Co., Ltd., Shenzhen, Guangdong 518129 (CN)
(72) Inventor: YUAN, Yi, Shenzhen Guangdong 518129 (CN); YANG, Ganghua, Shenzhen Guangdong 518129 (CN); HUANG, Maosheng, Shenzhen Guangdong 518129 (CN)
(74) Representative: Pfenning, Meinig & Partner GbR
(86) International application number: PCT/CN2011/073082
(87) International publication number: WO 2011/107057

(57) **Abstract**

The present invention discloses a data transmission method, a radio access network device, a wireless gateway and a system. A downlink data transmission method of a radio access network includes: when receiving a downlink data packet transmitted by a wireless core network device, compressing the downlink data packet; transmitting the compressed downlink data packet to a radio frequency module, where the compressed downlink data packet is sent in a wireless manner via an air interface. An uplink data transmission method of a wireless gateway includes: when receiving an uplink data packet transmitted by a user terminal, compressing the uplink data packet; transmitting the compressed uplink data packet to a radio frequency module, where the compressed uplink data packet is sent in a wireless manner via an air interface. In the data transmission method, the radio access network device, the wireless gateway and the system according to the present invention, by setting a compression function in a radio access network device or a wireless gateway, a data packet sent via an air interface may be compressed, thereby reducing a bandwidth occupied by the data packet, and correspondingly improving a resource transmission capability of the air interface.

## Description

### FIELD OF THE INVENTION

Embodiments of the present invention relate to wireless communication technologies, and in particular, to a data transmission method, a radio access network device, a wireless gateway and a system.

### BACKGROUND OF THE INVENTION

With the increasing of a data service capability of a cellular wireless broadband network, it becomes an option to use a cellular broadband wireless network to rapidly deploy a local area network which is connected to a public network.

This network system uses a wireless broadband local area gateway (wireless gateway for short) having a function of performing wireless communication with a cellular wireless broadband network as a transit, and the wireless gateway is connected to multiple access terminals, such as a computer, a portable computer and a mobile phone, in a wired or wireless manner. A wired access manner may be an Ethernet cable manner, a wireless access manner may be Wifi access and so on. The wireless gateway aggregates, downward, services of multiple users of a local area network, communicates, upward, with a base station of a cellular wireless broadband network, and accesses the public Internet or another specific service network via a cellular wireless local area network. In this way, the wireless gateway supports, inside the local area network, multiple devices of multiple users in accessing the Internet simultaneously, or multiple devices in using various services simultaneously. A standard of a cellular wireless broadband network is not limited, and a common standard is, for example, the enhanced data rate for GSM evolution (Enhanced Data Rate for GSM Evolution, EDGE for short), high-speed packet access (High-Speed Packet Access, HSPA for short), code division multiple access (Code Division Multiple Access, CDMA for short), long term evolution (Long Term Evolution, LTE for short) or world interoperability for microwave access (World Interoperability for Microwave Access, WiMAX for short); a cellular wireless broadband network is a public network which is operated by a mobile operator and meets a standard such as the 3rd generation partnership project 3 (3rd Generation Partnership Project 3, 3GPP3 for short), the 3rd generation partnership project 2 (3rd Generation Partnership Project 2, 3GPP2 for short) or the Institute of Electrical and Electronics Engineers (Institute of Electrical and Electronics Engineers, IEEE for short).

In this network architecture, a wired (such as 1000Base-T) and local area wireless manner (such as 802.11n) may be used inside a local area network, and a physical bandwidth may easily exceed 100 Mbps. A terrestrial link of a cellular wireless broadband network may also use an optical fiber and other manners, and potential of the physical bandwidth is unlimited in theory. However, an air interface between a radio access network of a cellular wireless broadband network and a wireless gateway of a local area network is shared by mobile users, covers a wide area cellular wireless network, is limited by a radio propagation environment and an available frequency width, and has a limited bandwidth capability, which, therefore, becomes a bottleneck for a bandwidth of a network system. Due to a bandwidth limit of an air interface, the number of terminals that access the Internet simultaneously in a wireless local area network is limited.

### SUMMARY OF THE INVENTION

Embodiments of the present invention provide a data transmission method, a radio access network device, a wireless gateway and a system, so as to reduce an impact on transmission of network system data caused by a bandwidth limit of an air interface.

An embodiment of the present invention provides a downlink data transmission method of a radio access network, where the method includes:
when a network side compression and decompression module of a radio access network device receives a downlink data packet transmitted by a wireless core network device, compressing the downlink data packet; and
transmitting, by the network side compression and decompression module, the compressed downlink data packet to a network side radio frequency module, where the compressed downlink data packet is sent in a wireless manner via an air interface.

An embodiment of the present invention further provides an uplink data transmission method of a radio access network, where the method includes:
when a network side compression and decompression module of a radio access network device acquires an uplink data packet which is received, in a wireless manner via an air interface, by a network side radio frequency module, decompressing the uplink data packet; and
transmitting, by the network side compression and decompression module, the decompressed uplink data packet to a wireless core network device.

An embodiment of the present invention further provides an uplink data transmission method of a wireless gateway, where the method includes:
when a user side compression and decompression module of the wireless gateway receives an uplink data packet transmitted by a user terminal, compressing the uplink data packet; and
transmitting, by the user side compression and decompression module, the compressed uplink data packet to a user side radio frequency module, where the compressed uplink data packet is sent in a wireless manner via an air interface.

An embodiment of the present invention further provides a downlink data transmission method of a wireless gateway, where the method includes:
when a user side compression and decompression module of the wireless gateway acquires a downlink data packet which is received, in a wireless manner via an air interface, by a user side radio frequency module, decompressing the downlink data packet; and
transmitting, by the user side compression and decompression module, the decompressed downlink data packet to a user terminal.

An embodiment of the present invention further provides an uplink data transmission method of a wireless network, where the method includes:
when a user side compression and decompression module of a wireless gateway receives an uplink data packet transmitted by a user terminal, compressing the uplink data packet;
transmitting, by the user side compression and decompression module, the compressed uplink data packet to a user side radio frequency module, where the compressed uplink data packet is sent in a wireless manner via an air interface;
when a network side compression and decompression module of a radio access network device acquires an uplink data packet which is received, in a wireless manner via an air interface, by a network side radio frequency module, decompressing the uplink data packet; and
transmitting, by the network side compression and decompression module, the decompressed uplink data packet to a wireless core network device.

An embodiment of the present invention further provides a downlink data transmission method of a wireless network, where the method includes:
when a network side compression and decompression module of a radio access network device receives a downlink data packet transmitted by a wireless core network device, compressing the downlink data packet;
transmitting, by the network side compression and decompression module, the compressed downlink data packet to a network side radio frequency module, where the compressed downlink data packet is sent in a wireless manner via an air interface;
when a user side compression and decompression module of a wireless gateway acquires a downlink data packet which is received, in a wireless manner via an air interface, by a user side radio frequency module, decompressing the downlink data packet; and
transmitting, by the user side compression and decompression module, the decompressed downlink data packet to a user terminal.

An embodiment of the present invention provides a radio access network device, including:
a network side compression and decompression module, configured to: when receiving a downlink data packet transmitted by a wireless core network device, compress the downlink data packet, and then transmit the compressed downlink data packet to a network side radio frequency module, and configured to: when acquiring an uplink data packet from the network side radio frequency module, decompress the uplink data packet, and then transmit the decompressed uplink data packet to the wireless core network device; and
the network side radio frequency module, configured to perform radio frequency processing on the downlink data packet transmitted by the network side compression and decompression module, and send the downlink data packet in a wireless manner via an air interface, and configured to perform radio frequency processing on an uplink data packet which is received in a wireless manner via an air interface, and transmit the uplink data packet to the network side compression and decompression module.

For the radio access network device as mentioned above, exemplarily, the radio access network device includes a base station unit and a base station controller unit, and the network side compression and decompression module is located in the base station unit or the base station controller unit.

An embodiment of the present invention further provides a wireless gateway, including:
a user side compression and decompression module, configured to: when receiving, via a routing module, an uplink data packet transmitted by a user terminal, compress the uplink data packet, and then transmit the compressed uplink data packet to a user side radio frequency module, and configured to: when acquiring a downlink data packet from the user side radio frequency module, decompress the downlink data packet, and then transmit the decompressed downlink data packet to the user terminal via the routing module;
the user side radio frequency module, configured to perform radio frequency processing on the uplink data packet transmitted by the user side compression and decompression module, and send the uplink data packet in a wireless manner via an air interface, and configured to perform radio frequency processing on a downlink data packet which is received in a wireless manner via an air interface, and transmit the downlink data packet to the user side compression and decompression module; and
the routing module, configured to perform routing processing on an uplink data packet or a downlink data packet exchanged between the user side compression and decompression module and the user terminal.

An embodiment of the present invention further provides a data transmission network system, including a radio access network device and a wireless gateway provided in the embodiments of the present invention.

In a data transmission method, device and system of a radio access network and a wireless gateway according to the embodiments of the present invention, by setting a compression function in a radio access network device or the wireless gateway, a data packet sent via an air interface may be compressed, thereby reducing a bandwidth occupied by the data packet and correspondingly improving a resource transmission capability of the air interface.

### BRIEF DESCRIPTION OF THE DRAWINGS

FIG. 1 is a flow chart of a downlink data transmission method of a radio access network according to Embodiment 1 of the present invention;

FIG. 2A is a schematic diagram of a network system architecture applicable to an embodiment of the present invention;

FIG. 2B is a structural diagram of a network system architecture applicable to an embodiment of the present invention;

FIG. 3 is a flow chart of an uplink data transmission method of a radio access network according to Embodiment 2 of the present invention;

FIG. 4 is a flow chart of an uplink data transmission method of a wireless gateway according to Embodiment 3 of the present invention;

FIG. 5 is a flow chart of a downlink data transmission method of a wireless gateway according to Embodiment 4 of the present invention;

FIG. 6 is a schematic structural diagram of a radio access network device according to Embodiment 5 of the present invention;

FIG. 7A is a schematic structural diagram 1 where a radio access network device according to an embodiment of the present invention is applicable to a wireless packet switched network;

FIG. 7B is a schematic structural diagram 2 where a radio access network device according to an embodiment of the present invention is applicable to a wireless packet switched network;

FIG. 7C is a schematic structural diagram 1 where a radio access network device according to an embodiment of the present invention is applicable to a CDMA network;

FIG. 7D is a schematic structural diagram 2 where a radio access network device according to an embodiment of the present invention is applicable to a CDMA network;

FIG. 7E is a schematic structural diagram 1 where a radio access network device according to an embodiment of the present invention is applicable to a WiMAX wireless network;

FIG. 7F is a schematic structural diagram 2 where a radio access network device according to an embodiment of the present invention is applicable to a WiMAX wireless network; and

FIG. 8 is a schematic structural diagram of a wireless gateway according to Embodiment 6 of the present invention.

### DETAILED DESCRIPTION OF THE EMBODIMENTS

To make objectives, technical solutions, and advantages of embodiments of the present invention more comprehensible, the technical solutions in the embodiments of the present invention are clearly and completely described in the following with reference to the accompanying drawings in the embodiments of the present invention. Apparently, the embodiments to be described are merely part rather than all of the embodiments of the present invention. All other embodiments obtained by persons of ordinary skill in the art based on the embodiments of the present invention without creative efforts shall fall within the protection scope of the present invention.

### Embodiment 1

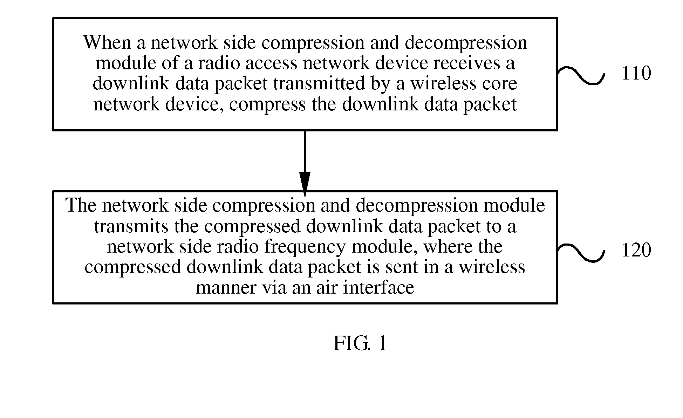

FIG. 1 is a flow chart of a downlink data transmission method of a radio access network according to Embodiment 1 of the present invention.

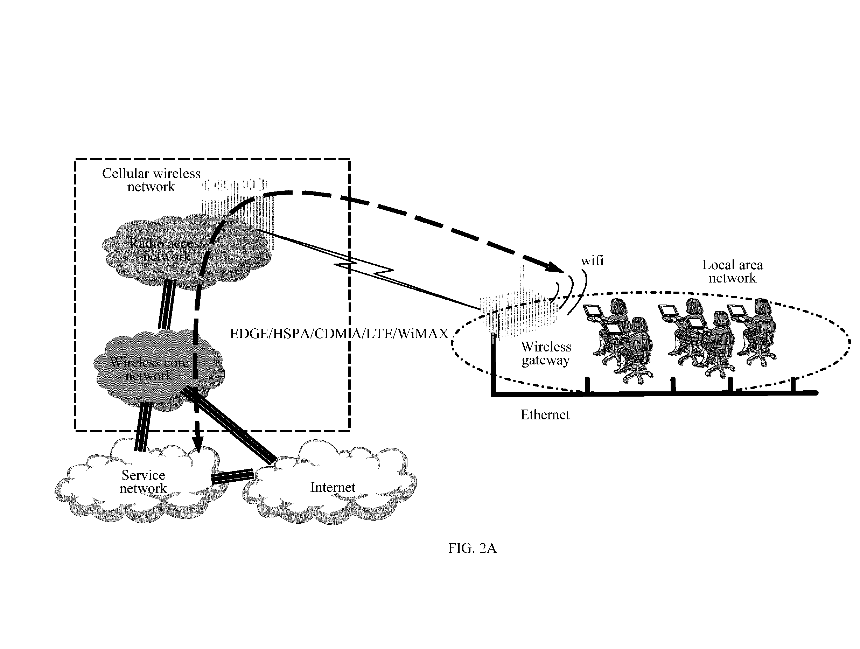

A network system architecture applicable to this embodiment is shown in FIG. 2A, and includes two parts, a wireless network device and a device of the Internet and a local area network. On a wireless network side, a wireless network may adopt a standard such as the EDGE, HSPA, CDMA, LTE or Wimax, and is a public network which is operated by a mobile operator and meets standards such as 3GPP/3GPP2/IEEE. A wireless core network is connected to the Internet. Various servers for providing data services are disposed in the Internet, such as a storage server, a compression server and multiple content servers. On a local area network side, a wireless gateway, and multiple user terminals which interact with the wireless network via the wireless gateway are mainly involved. A user terminal accesses the Internet via the wireless gateway, the radio access network and the wireless core network.

In this embodiment, the downlink data transmission method specifically executed by a radio access network device can improve a downlink bandwidth of a wireless air interface of a radio access network, and includes the following steps:

Step 110: When a network side compression and decompression module of the radio access network device receives a downlink data packet transmitted by a wireless core network device, compress the downlink data packet.

Step 120: The network side compression and decompression module of the radio access network device transmits the compressed downlink data packet to a network side radio frequency module, where the compressed downlink data packet is sent in a wireless manner via an air interface.

After step 120, decompression may be performed correspondingly in the local area network side, and the downlink data packet is decompressed in the user terminal or in the wireless gateway.

In the embodiment of the present invention, by setting a compression function in a radio access network device, a downlink data packet sent via an air interface may be compressed, thereby reducing a bandwidth occupied by the downlink data packet, and correspondingly improving a resource transmission capability of the air interface. Because the compression function is implemented in the radio access network device, in one aspect, whether a server provided by each operator in a wireless core network performs compression and which compression algorithm is adopted do not need to be taken into consideration, and the radio access network device may perform uniform compression processing, which has high generality and facilitates management as well as unification of compression algorithms. For example, a fixed bit length algorithm, a run-length encoding (Run-Length Encoding, RLE for short) algorithm, an LZ77 algorithm and Huffman encoding may be adopted. In another aspect, for radio frequency transmission devices of a wireless core network and a radio access network, their respective hardware and software do not need to be changed, and only the compression function needs to be integrated directly between them, which requires small changes to the prior art and is easy to be promoted.

### Embodiment 2

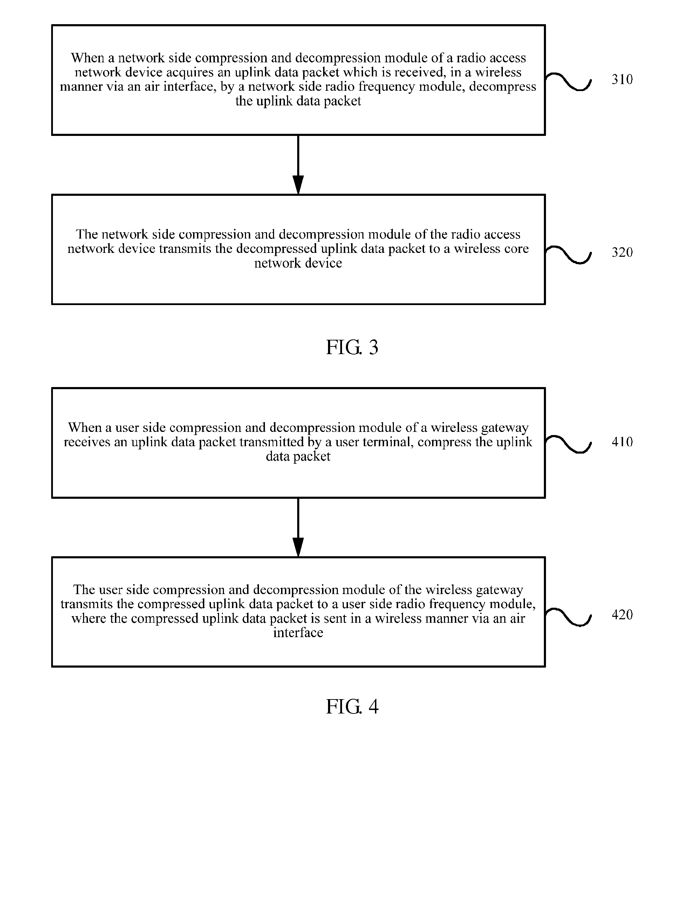

FIG. 3 is a flow chart of an uplink data transmission method of a radio access network according to Embodiment 2 of the present invention, and this embodiment is also applicable to a network system architecture shown in FIG. 2A. The method is specifically executed by a radio access network device and is a method for a radio access network to improve an uplink bandwidth of a wireless air interface. The method specifically includes the following steps:

Step 310: When a network side compression and decompression module of the radio access network device acquires an uplink data packet which is received, in a wireless manner via an air interface, by a network side radio frequency module, decompress the uplink data packet.

In step 310, the compressed uplink data packet may be an uplink data packet which is of a local area network side and is formed through compression by a user terminal or a wireless gateway.

Step 320: The network side compression and decompression module of the radio access network device transmits the decompressed uplink data packet to a wireless core network device.

This embodiment is similar to Embodiment 1, and a difference is that an uplink bandwidth of an air interface of the radio access network may be improved and decompression processing may be performed on the compressed data packet.

Exemplarily, decompression processing of the uplink data packet and compression processing of a downlink data packet are executed simultaneously in the radio access network device, thereby improving uplink and downlink bandwidths of a wireless air interface simultaneously.

### Embodiment 3

FIG. 4 is a flow chart of an uplink data transmission method of a wireless gateway according to Embodiment 3 of the present invention, where the method is also applicable to a network system architecture shown in FIG. 2A, is specifically an Internet accessing method executed by a wireless gateway in a local area network, may improve an uplink bandwidth of a wireless air interface of the local area network, and includes the following steps:

Step 410: When a user side compression and decompression module of the wireless gateway receives an uplink data packet transmitted by a user terminal, compress the uplink data packet.

The foregoing step may specifically be: The user terminal submits an access request or uploads data as the uplink data packet, and a routing module routes the uplink data packet to the wireless gateway.

Step 420: The user side compression and decompression module of the wireless gateway transmits the compressed uplink data packet to a user side radio frequency module, where the compressed uplink data packet is sent in a wireless manner via an air interface.

In step 420, after the wireless gateway sends the compressed uplink data packet via the air interface, correspondingly, a radio access network device or a wireless core network device in a wireless network side or a server of the Internet decompresses the uplink data packet.

In this embodiment, by setting a compression function in a wireless gateway, an uplink data packet sent via an air interface may be compressed, thereby reducing a bandwidth occupied by the uplink data packet, and correspondingly improving a resource transmission capability of the air interface. Because the compression function is implemented in the wireless gateway, in one aspect, whether a user terminal provided by each operator performs compression and which compression algorithm is adopted do not need to be taken into consideration, the wireless gateway may perform uniform compression processing, which has high generality and facilitates management as well as unification of compression algorithms. In another aspect, for radio frequency transmission devices of a user terminal and a wireless gateway, their respective hardware and software do not need to be changed, and only the compression function needs to be integrated directly between them, which requires small changes to the prior art and is easy to be promoted.

### Embodiment 4

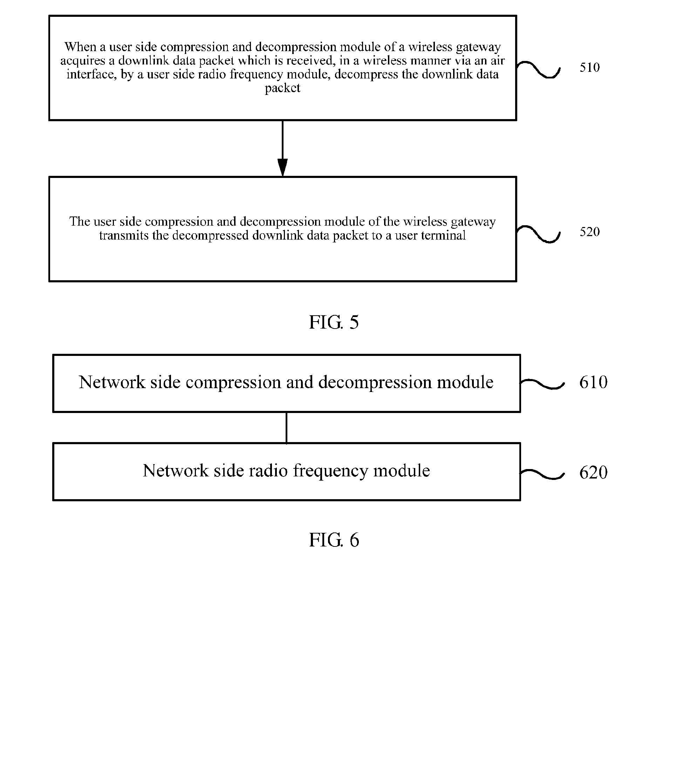

FIG. 5 is a flow chart of a downlink data transmission method of a wireless gateway according to Embodiment 4 of the present invention, where the method is also applicable to a network system architecture shown in FIG. 2A, is specifically a method for improving a downlink bandwidth of a wireless air interface executed by a wireless gateway in a local area network, and includes the following steps:

Step 510: When a user side compression and decompression module of the wireless gateway acquires a downlink data packet which is received, in a wireless manner via an air interface, by a user side radio frequency module, decompress the downlink data packet.

Step 520: The user side compression and decompression module of the wireless gateway transmits the decompressed downlink data packet to a user terminal, and specifically the data packet may be routed to the user terminal via a routing module.

This embodiment is similar to Embodiment 3, and a difference is that a downlink bandwidth of an air interface of a local area network may be improved and decompression processing may be performed on the compressed data packet. Exemplarily, decompression processing of the downlink data packet and compression processing of an uplink data packet are executed simultaneously in the wireless gateway of the local area network, thereby improving uplink and downlink bandwidths of the wireless air interface simultaneously. That is, for example, in Embodiment 3 after an access request is sent or data is uploaded in an uplink direction, a compressed downlink response is received via a wireless air interface, and the wireless gateway may decompress downlink response data, and transmit the decompressed downlink response data to the user terminal in a downlink direction.

For respective uplink and downlink data transmission methods of a radio access network and a wireless gateway according to the embodiments of the present invention, exemplarily, a radio access network device and a wireless gateway implement a compression and decompression solution in a cooperative manner, may implement the compression and decompression solution on uplink data packets only, and may also implement the compression and decompression solution on downlink data packets only. Exemplarily, the compression and decompression solution is implemented on uplink data packets and downlink data packets simultaneously, which saves bandwidths to a maximum extent.

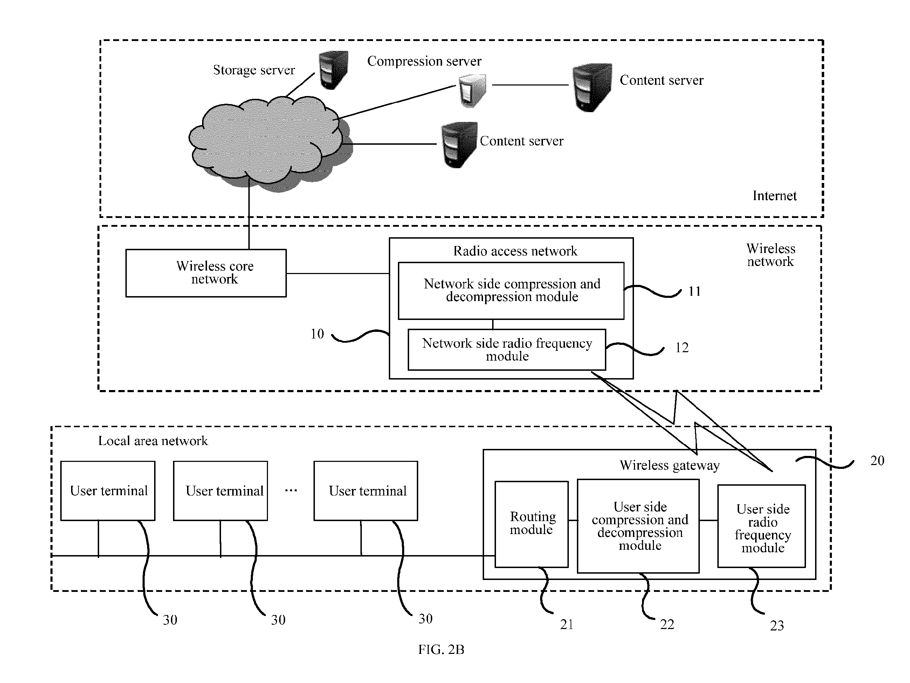

The radio access network device and the wireless gateway may set a compression and decompression algorithm through negotiation in advance, and a compression and decompression module is disposed in the radio access network device and the wireless gateway, as shown in FIG. 2B. At least a compression and decompression module and a radio frequency module are disposed in a device of a radio access network 10, and to differ from a structure of the wireless gateway, the compression and decompression module and the radio frequency module in the device of the radio access network 10 are marked as a network side compression and decompression module 11 and a network side radio frequency module 12. The network side radio frequency module 12 performs radio frequency processing on data packets received and sent via an air interface. A wireless gateway 20 includes at least a routing module 21, a compression and decompression module, and a radio frequency module. For the purpose of differentiation, the compression and decompression module and the radio frequency module in the wireless gateway 20 are marked as a user side compression and decompression module 22 and a user side radio frequency module 23. Similarly, the user side radio frequency module 23 is configured to perform normal radio frequency processing, and the routing module 21 is configured to provide a data routing function with a user terminal 30.

Based on compression and decompression functions of the radio access network device and the wireless gateway, an embodiment of the present invention further provides an uplink data transmission method of a wireless network, where the method is implemented by the radio access network and the wireless gateway of the local area network in a cooperative manner. The method may specifically be a method for improving an uplink bandwidth of an air interface of the wireless network, and includes the following steps:

When the user side compression and decompression module of the wireless gateway receives an uplink data packet transmitted by the user terminal, compress the uplink data packet.

The user side compression and decompression module transmits the compressed uplink data packet to the user side radio frequency module, where the compressed uplink data packet is sent in a wireless manner via an air interface.

When a network side compression and decompression module of the radio access network device acquires an uplink data packet which is received, in a wireless manner via an air interface, by a network side radio frequency module, decompress the uplink data packet.

The network side compression and decompression module transmits the decompressed uplink data packet to a wireless core network device.

An embodiment of the present invention further provides a downlink data transmission method of the wireless network, where the method is implemented by the radio access network and the wireless gateway of the local area network in a cooperative manner. The method may specifically be a method for improving a downlink bandwidth of an air interface of the wireless network, and includes the following steps:

When the network side compression and decompression module of the radio access network device receives a downlink data packet transmitted by a wireless core network device, compress the downlink data packet.

The network side compression and decompression module transmits the compressed downlink data packet to a network side radio frequency module, where the compressed downlink data packet is sent in a wireless manner via an air interface.

When the user side compression and decompression module of the wireless gateway acquires a downlink data packet which is received, in a wireless manner via an air interface, by the user side radio frequency module, decompress the downlink data packet.

The user side compression and decompression module transmits the decompressed downlink data packet to the user terminal.

In the foregoing technical solutions, a radio access network and a wireless gateway of a local area network may implement compression and decompression of data packets in a cooperative manner, thereby reducing sizes of data packets and increasing a capability of a wireless air interface to transmit a data packet.

### Embodiment 5

FIG. 6 is a schematic structural diagram of a radio access network device according to Embodiment 5 of the present invention, where the radio access network device includes a compression and decompression module and a radio frequency module, which are marked as a network side compression and decompression module 610 and a network side radio frequency module 620 to differ from those of a wireless gateway. The network side compression and decompression module 610 may be disposed between a wireless core network device and the network side radio frequency module 620, and is configured to: when receiving a downlink data packet transmitted by the wireless core network device, compress the downlink data packet, and then transmit the compressed downlink data packet to the network side radio frequency module 620, and is configured to: when acquiring an uplink data packet from the network side radio frequency module 620, decompress the uplink data packet, and then transmit the decompressed uplink data packet to the wireless core network device; the network side radio frequency module 620 may interact with the network side compression and decompression module 610, and is configured to perform radio frequency processing on the downlink data packet transmitted by the network side compression and decompression module 610, and send the downlink data packet in a wireless manner via an air interface, and is configured to perform radio frequency processing on an uplink data packet which is received in a wireless manner via an air interface, and transmit the uplink data packet to the network side compression and decompression module 610.

The radio access network device generally includes a base station unit and a base station controller unit, and this compression and decompression module may be located in the base station unit, or may also be located in the base station controller unit.

The radio access network device according to this embodiment may execute the data transmission method of the radio access network according to the embodiment of the present invention, has corresponding functional modules, and can reduce bytes occupied by data packets through uniform compression and decompression processing, thereby improving a bandwidth capability of a wireless air interface.

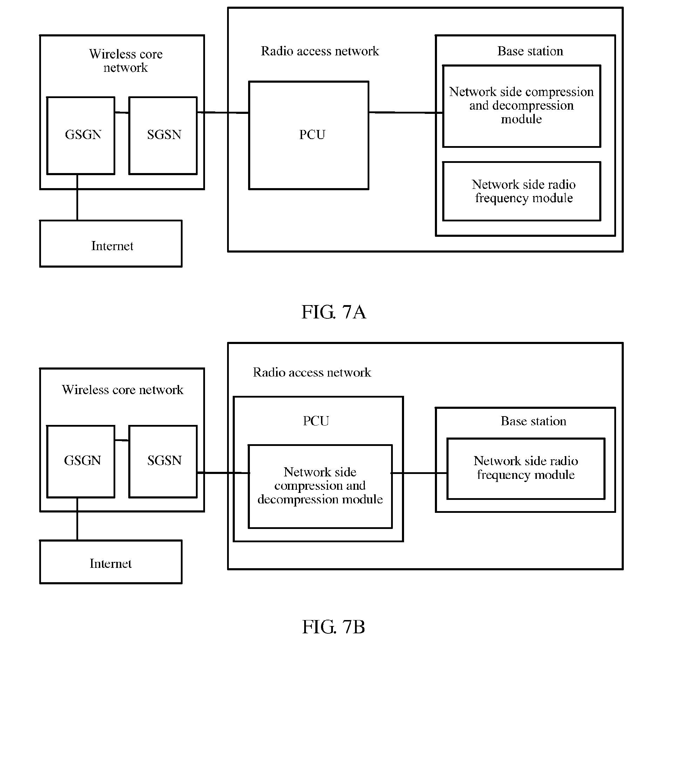

For different wireless networks, wireless core networks and radio access networks are also formed differently, and positions of compression and decompression modules are also set differently. Taking a wireless packet switched network of GRPS, EDGE or HSPA as an example, a wireless network is formed of a wireless core network and a radio access network. The wireless core network includes a serving GPRS (general packet radio service, General Packet Radio Service) support node (Serving GPRS Support Node, SGSN for short) and a gateway GPRS support node (Gateway GPRS Support Node, GSGN for short); the radio access network includes a packet control unit (Package Control Unit, PCU for short), a base station and so on. The network side compression and decompression module and the network side radio frequency module may be disposed in the base station, as shown in FIG. 7A. Alternatively, as shown in FIG. 7B, the network side compression and decompression module is located in the PCU and the network side radio frequency module is located in the base station.

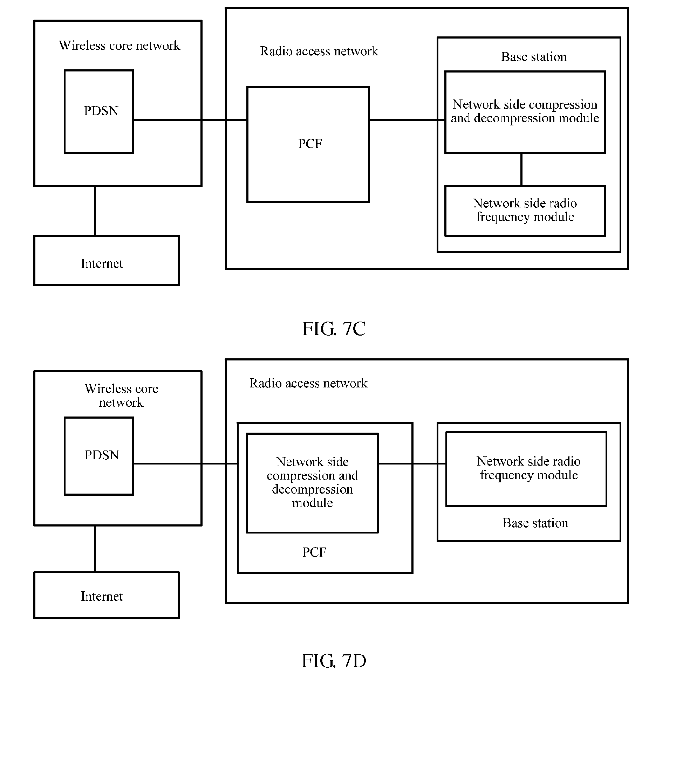

Taking a CDMA wireless network as an example, a wireless network is formed of a wireless core network and a radio access network, the wireless core network includes a packet data serving node (Packet Data Serving Node, PDSN for short), and the radio access network includes a PCF (CDMA packet data field control function), a base station and so on. The network side compression and decompression module and the network side radio frequency module may be located in the base station, as shown in FIG. 7C. Alternatively, in the CDMA network, the network side compression and decompression module may be located in the PCF and the network side radio frequency module may be located in the base station, as shown in FIG. 7D.

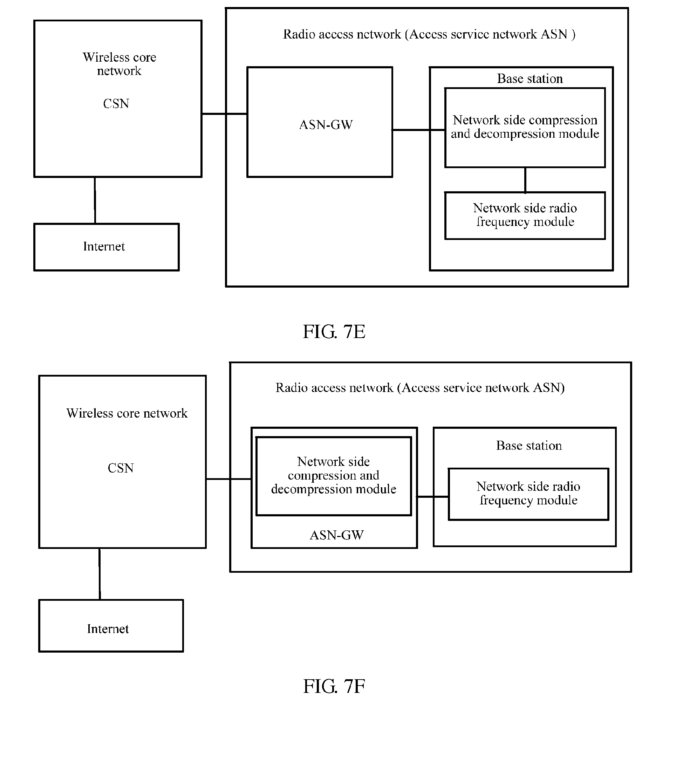

For a WiMAX wireless network, a wireless network is formed of a wireless core network and a radio access network, the wireless core network is a connectivity service network (Connectivity Service Network, CSN for short), the radio access network is an access service network (Access Service Network, ASN for short), including an access service network gateway (Access Service Network Gateway, ASN-GW for short), a base station and so on. The network side compression and decompression module and the network side radio frequency module are located in the base station, as shown in FIG. 7E. Alternatively, for the same WiMAX network, the network side compression and decompression module is located in the ASN-GW and the network side radio frequency module is located in the base station, as shown in FIG. 7F.

### Embodiment 6

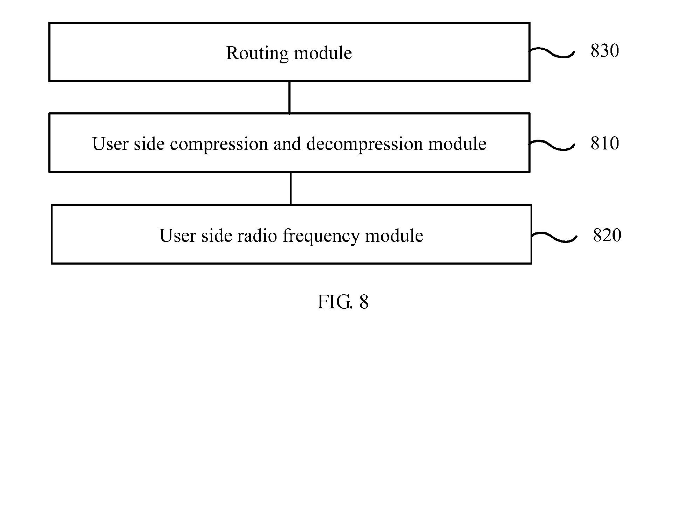

FIG. 8 is a schematic structural diagram of a wireless gateway according to Embodiment 6 of the present invention, and this wireless gateway includes a compression and decompression module, a radio frequency module and a routing module 830, which are marked as a user side compression and decompression module 810, a user side radio frequency module 820 and a routing module 830 for differentiation. The user side compression and decompression module 810 may be disposed between the routing module 830 and the user side radio frequency module 820, and is configured to: when receiving, via the routing module 830, an uplink data packet transmitted by a user terminal, compress the uplink data packet, and then transmit the compressed uplink data packet to the user side radio frequency module 820, and is configured to: when acquiring a downlink data packet from the user side radio frequency module 820, decompress the downlink data packet, and then transmit the decompressed downlink data packet to the user terminal via the routing module 830. The user side radio frequency module 820 may interact with the user side compression and decompression module 810, and is configured to perform radio frequency processing on the uplink data packet transmitted by the user side compression and decompression module 810, and send the uplink data packet in a wireless manner via an air interface, and is configured to perform radio frequency processing on a downlink data packet which is received in a wireless manner via an air interface, and transmit the downlink data packet to the user side compression and decompression module 810. The routing module 830 may interact with the user side compression and decompression module 810, and is configured to perform routing processing on the uplink data packet or the downlink data packet exchanged between the user side compression and decompression module 810 and the user terminal.

The wireless gateway according to this embodiment may execute the data transmission method of the wireless gateway according to the embodiment of the present invention, has corresponding functional modules, and can reduce bytes occupied by data packets through uniform compression and decompression processing, thereby improving a bandwidth capability of a wireless air interface.

An embodiment of the present invention further provides a data transmission network system, including the radio access network device and the wireless gateway according to any embodiment of the present invention. Through cooperation of a wireless network side and a local area network side, bandwidth utilization of a wireless air interface is improved. When a local area network accesses an Internet network server via the wireless gateway and the wireless network, utilization of uplink and downlink bandwidths of the air interface between the wireless gateway and the radio access network is improved, a limit on the number of user terminals that access the Internet simultaneously in a local area network is reduced, and the number of user terminals that access the Internet simultaneously in a wireless local area network is increased.

Persons skilled in the art may understand that the foregoing radio frequency module and compression and decompression module are not the unique structure in the radio access network device or the wireless gateway, the radio access network device and the wireless gateway may also dispose another corresponding functional module according to other requirements. An interaction relationship or a connection between the foregoing modules may be a direct or indirect connection, transmission of a data packet may be direct transmission, and may also be indirect transmission via another network element or transmission after other required processing.

Persons of ordinary skill in the art may understand that all or part of the steps of the foregoing method embodiments may be implemented by a program instructing relevant hardware. The program may be stored in a computer readable storage medium. When the program runs, the steps of the foregoing method embodiments are performed. The storage medium includes any medium that is capable of storing program codes, such as a ROM, a RAM, a magnetic disk, or an optical disk.

Finally, it should be noted that the foregoing embodiments are merely intended for describing the technical solutions of the present invention rather than limiting the present invention. Although the present invention is described in detail with reference to the foregoing embodiments, persons of ordinary skill in the art should understand that they may still make modifications to the technical solutions recorded in the foregoing embodiments or make equivalent substitutions to part of technical features in the technical solutions recorded in the foregoing embodiments; however, these modifications or substitutions do not make the essence of the corresponding technical solutions depart from the spirit and scope of the technical solutions of the embodiments of the present invention.

## Claims

1. A downlink data transmission method of a radio access network, comprising:
when a network side compression and decompression module of a radio access network device receives a downlink data packet transmitted by a wireless core network device, compressing the downlink data packet; and
transmitting, by the network side compression and decompression module, the compressed downlink data packet to a network side radio frequency module, wherein the compressed downlink data packet is sent in a wireless manner via an air interface.

2. An uplink data transmission method of a radio access network, comprising:
when a network side compression and decompression module of a radio access network device acquires an uplink data packet which is received, in a wireless manner via an air interface, by a network side radio frequency module, decompressing the uplink data packet; and
transmitting, by the network side compression and decompression module, the decompressed uplink data packet to a wireless core network device.

3. An uplink data transmission method of a wireless gateway, comprising:
when a user side compression and decompression module of the wireless gateway receives an uplink data packet transmitted by a user terminal, compressing the uplink data packet; and
transmitting, by the user side compression and decompression module, the compressed uplink data packet to a user side radio frequency module, wherein the compressed uplink data packet is sent in a wireless manner via an air interface.

4. A downlink data transmission method of a wireless gateway, comprising:
when a user side compression and decompression module of the wireless gateway acquires a downlink data packet which is received, in a wireless manner via an air interface, by a user side radio frequency module, decompressing the downlink data packet; and
transmitting, by the user side compression and decompression module, the decompressed downlink data packet to a user terminal.

5. An uplink data transmission method of a wireless network, comprising:
when a user side compression and decompression module of a wireless gateway receives an uplink data packet transmitted by a user terminal, compressing the uplink data packet;
transmitting, by the user side compression and decompression module, the compressed uplink data packet to a user side radio frequency module, wherein the compressed uplink data packet is sent in a wireless manner via an air interface;
when a network side compression and decompression module of a radio access network device acquires an uplink data packet which is received, in a wireless manner via an air interface, by a network side radio frequency module, decompressing the uplink data packet; and
transmitting, by the network side compression and decompression module, the decompressed uplink data packet to a wireless core network device.

6. A downlink data transmission method of a wireless network, comprising:
when a network side compression and decompression module of a radio access network device receives a downlink data packet transmitted by a wireless core network device, compressing the downlink data packet;
transmitting, by the network side compression and decompression module, the compressed downlink data packet to a network side radio frequency module, wherein the compressed downlink data packet is sent in a wireless manner via an air interface;
when a user side compression and decompression module of a wireless gateway acquires a downlink data packet which is received, in a wireless manner via an air interface, by a user side radio frequency module, decompressing the downlink data packet; and
transmitting, by the user side compression and decompression module, the decompressed downlink data packet to a user terminal.

7. A radio access network device, comprising:
a network side compression and decompression module, configured to: when receiving a downlink data packet transmitted by a wireless core network device, compress the downlink data packet, and then transmit the compressed downlink data packet to a network side radio frequency module, and configured to: when acquiring an uplink data packet from the network side radio frequency module, decompress the uplink data packet, and then transmit the decompressed uplink data packet to the wireless core network device; and
the network side radio frequency module, configured to perform radio frequency processing on the downlink data packet transmitted by the network side compression and decompression module, and send the downlink data packet in a wireless manner via an air interface, and configured to perform radio frequency processing on an uplink data packet which is received in a wireless manner via an air interface, and transmit the uplink data packet to the network side compression and decompression module.

8. The radio access network device according to claim 7, wherein the radio access network device comprises a base station unit and a base station controller unit, and the network side compression and decompression module is located in the base station unit or the base station controller unit.

9. A wireless gateway, comprising:
a user side compression and decompression module, configured to: when receiving, via a routing module, an uplink data packet transmitted by a user terminal, compress the uplink data packet, and then transmit the compressed uplink data packet to a user side radio frequency module, and configured to: when acquiring a downlink data packet from the user side radio frequency module, decompress the downlink data packet, and then transmit the decompressed downlink data packet to the user terminal via the routing module;
the user side radio frequency module, configured to perform radio frequency processing on the uplink data packet transmitted by the user side compression and decompression module, and send the uplink data packet in a wireless manner via an air interface, and configured to perform radio frequency processing on a downlink data packet which is received in a wireless manner via an air interface, and transmit the downlink data packet to the user side compression and decompression module; and
the routing module, configured to perform routing processing on an uplink data packet or a downlink data packet exchanged between the user side compression and decompression module and the user terminal.

10. A data transmission network system, comprising: the radio access network device according to claim 7 or claim 8 and the wireless gateway according to claim 9.
